# EUROPEAN PATENT APPLICATION

(11) **EP 3 502 062 A1**
(43) Date of publication of application: **26.06.2019**
(21) Application number: 17841539.4
(22) Date of filing: 17.08.2017
(51) Int. Cl.: C02F 1/46, C02F 1/68, H01L 21/304

(54) **HYDROGENCARBONATE WATER AND CLEANING METHOD USING SAME**

(30) Priority: 19.08.2016 KR 20160105253
(71) Applicant: Gohda Water Treatment Technology Co., Inc., Tokyo 104-0041 (JP); Mag Technology Co., Ltd., Suwon-Si, Gyeonggi-Do 441813 (KR)
(72) Inventor: GOHDA, Toshihisa, Tokyo 104-0041 (JP); LEE, Jae Yong, Goyang-si Gyeonggi-do 10424 (KR)
(74) Representative: TBK
(86) International application number: PCT/JP2017/029515
(87) International publication number: WO 2018/034317

(57) **Abstract**

The present invention relates to hydrogencarbonate water and a cleaning method using the hydrogencarbonate water. Provided are hydrogencarbonate water obtained by dissolving carbon dioxide in hydrogen water having a dissolved hydrogen concentration of 0.1 ppm to 2.0 ppm; and a cleaning method comprising cleaning a substrate by immersing the substrate in the hydrogencarbonate water, or spraying the hydrogencarbonate water to the substrate.

## Description

### Technical Field

The present invention relates to hydrogencarbonate water and a cleaning method using the hydrogencarbonate water. Particularly, the present invention relates to hydrogencarbonate water which is obtained by dissolving carbon dioxide in hydrogen water, which has reducing power while being acidic and which has a high electric conductivity; and a method of cleaning a substrate or the like using the hydrogencarbonate water.

### Background Art

In recent years, with advancement of capacity enhancement and densification, a substrate to be used in preparation of a semiconductor wafer, an organic EL (OLED), a photomask, an LCD, a hard disk or the like has been required to be thoroughly cleaned of even minute foreign matters so that minute patterns or the like do not come into electrical contact with the foreign matters. Various methods of cleaning such a substrate have been proposed, and these methods are classified broadly into wet cleaning, mechanical cleaning and dry cleaning. The wet cleaning is a method in which a substrate or the like is immersed in a chemical liquid to remove contaminants by a method such as chemical dissolution, the mechanical cleaning is a method in which ice, dry ice, aerosol or the like is sprayed to a surface of a substrate to remove particles and the like, and the dry cleaning is a method in which a gaseous oxidizing atmosphere is produced, and in this state, a plasma discharge or an ultraviolet ray is applied to remove contaminants. Patent Documents 1 to 3 each disclose a technique relating to such cleaning of a substrate.

Patent Document 1 suggests a cleaning liquid enabling high-quality cleaning even for novel solder such as lead-free solder, cleaning equipment, and a method of cleaning a mounting substrate, and discloses cleaning a mounting substrate with a cleaning liquid. The cleaning liquid is a chemical liquid obtained by including an organic amine in a hydrocarbon-based solvent containing ketone or an aromatic, and adding an unsaturated carboxylic anhydride compound or a carboxylic anhydride to the solvent. The organic amine contains at least one or more of diethanolamine, trimethylamine or the like which is a secondary amine or a tertiary amine, the cleaning liquid contains at least one or more of a dehydrated unsaturated carboxylic acid compound (abietic anhydride, neoabietic anhydride or the like) or a dehydrated carboxylic acid (formic acid, acetic anhydride, valeric anhydride or the like), and the amount of the amine compound is not more than the total amount of the carboxylic acid species.

Patent Document 2 discloses a substrate treatment apparatus, the substrate treatment apparatus includes a housing providing therein a space in which a substrate is treated; a spin head which supports and rotates a substrate in the housing; a substrate placed on the spin head; a spray unit having a first nozzle member which sprays a first treatment liquid; and a controller which controls the spray unit, the first nozzle member includes a main body including a first discharge port for spraying the first treatment liquid at the substrate with the spray unit communicating with a spray channel through which the first treatment liquid flows; and a vibrator placed in the main body to provide vibrations to the first treatment liquid flowing through the spray channel, and the controller is configured to perform control so that after the first nozzle member is situated at a first set position with respect to the substrate, the first nozzle member is moved in a perpendicular direction with respect to the substrate at the first set position and the first treatment liquid is sprayed during a first time, followed by moving the first nozzle member in a horizontal direction with respect to the substrate and spraying the first treatment liquid during a second time.

Patent Document 3 discloses a method of cleaning a semiconductor substrate using a gas-liquid hybrid atmospheric pressure plasma under a weakly acidic aqueous solution. The method can replace use of a strongly acidic or strongly basic cleaning liquid which has been used in a conventional semiconductor cleaning step, so that the method is not only capable of reducing cost, but also very environmentally friendly because waste water with a strongly acidic or strongly basic cleaning liquid is not generated.

However, contaminating particles remaining on a surface of a substrate vary depending on the type of the substrate, a method of preparation of the substrate, materials to be used, and the like. For contaminating substances difficult to clean off in a simple manner, such as metal particles, a chemical agent such as ammonia or sulfuric acid is used, but use of the chemical agent causes the following problems.
(1) While the chemical agent has an effect of removing contaminating substances, patterns or the like formed on the substrate may be eliminated along with the contaminating substances, or damaged, and thus the chemical agent must be thoroughly removed from the substrate using water or the like after use of the chemical agent.
(2) In addition, drainage water used for removal of the chemical agent has toxicity, and therefore not only has a risk of harming human bodies, but also requires attentiveness to waste water treatment.
(3) Further, a large amount of water is needed for removing the chemical agent remaining on the substrate after use of the chemical agent.

As one of methods for solving these problems, a new cleaning technique capable of removing impurities without use of the chemical agent is desired.

### Prior Art Documents

### Patent Documents

Patent Document 1: Korean Patent Publication No. 10-2015-0122061
Patent Document 2: Korean Patent Publication No. 10-2016-0049167
Patent Document 3: Korean Patent registration No. 1647586

### Summary of the Invention

### Object to be Solved by the Invention

An object of the present invention is to solve the above-described problems, and provide a cleaning liquid having a high cleaning effect even without using a chemical agent. Particularly, the object of the present invention is to provide a cleaning liquid which has reducing power in terms of an oxidation-reduction potential while being acidic and which has a high electric conductivity. Further, an object of the present invention is to provide a cleaning method which uses the cleaning liquid, which has a high cleaning effect and which does not cause generation of a chemical agent and drainage water containing the chemical agent in water.

### Means to Solve the Object

The present inventors have conducted studies with attention paid to hydrogen water for solving the above-described objects, and resultantly found that when carbon dioxide is dissolved in hydrogen water having a dissolved hydrogen concentration of 0.1 ppm to 2.0 ppm, it is possible to obtain hydrogencarbonate water which has reducing power in terms of an oxidation-reduction potential while being acidic and which has an increased electric conductivity, and when the hydrogencarbonate water is used for cleaning a substrate, a cleaning effect can be improved while formation of an oxide film on patterns formed on the substrate is suppressed with high reducing power even if the patterns come into contact with the hydrogencarbonate water, and since a chemical agent is not used, a rinsing step after use of the chemical agent can be eliminated, so that it is possible to provide a safe cleaning liquid enabling reduction of the number of cleaning steps, and a method of cleaning a surface of a substrate using the cleaning liquid.

That is, the present invention is specified by the matters shown below.
(1) Hydrogencarbonate water obtained by dissolving carbon dioxide in hydrogen water having a dissolved hydrogen concentration of 0.1 ppm to 2.0 ppm.
(2) The hydrogencarbonate water according to above (1), wherein the hydrogen water has a pH of 5.5 to 6.8, an oxidation-reduction potential of -200 mV to -700 mV and a dissolved hydrogen concentration of 0.1 ppm to 2.0 ppm.
(3) The hydrogencarbonate water according to above (1) or (2), wherein the hydrogen water is hydrogen water obtained by dissolving hydrogen gas in pure water or ultrapure water, or hydrogen water obtained by electrolyzing pure water or ultrapure water.
(4) Hydrogencarbonate water having a pH of 4.0 to 6.8, an oxidation-reduction potential of -50 mV to -650 mV and an electric conductivity of 0.072 µS/cm to 80 µS/cm.
(5) The hydrogencarbonate water according to any one of above (1) to (3), wherein the hydrogencarbonate water has a pH of 4.0 to 6.8, an oxidation-reduction potential of -50 mV to -650 mV and an electric conductivity of 0.072 µS/cm to 80 µS/cm.
(6) A cleaning method comprising cleaning a substrate by immersing the substrate in the hydrogencarbonate water according to any one of above (1) to (5), or spraying to the substrate the hydrogencarbonate water according to any one of above (1) to (5).
(7) The cleaning method according to above (6), wherein the substrate is cleaned by spraying the hydrogencarbonate water to the substrate for 5 to 10 minutes while rotating the substrate at 80 to 300 rpm and applying a megasonic at 1 to 3 MHz to the hydrogencarbonate water.
(8) The cleaning method according to above (6) or (7), wherein the hydrogencarbonate water is preheated at 40°C to 85°C.

### Effects of the Invention

Hydrogencarbonate water of the present invention and a cleaning method using the hydrogencarbonate water have the following effects.
(1) Carbon dioxide (CO₂) is dissolved in hydrogen water to obtain hydrogencarbonate water which has reducing power in terms of an oxidation-reduction potential while being an acid and which has a particularly high electric conductivity, and in this way, it is possible to obtain a cleaning liquid having high cleaning power even without using a chemical agent.
(2) The hydrogencarbonate water having high reducing power can improve a fine particle removal ratio at the time of cleaning a substrate, and has reducing power so high that formation of an oxide film on patterns formed on the substrate can be suppressed to further improve the cleaning effect.
(3) When a megasonic at 1 to 3 MHz is applied to the hydrogencarbonate water at the time of cleaning the substrate, megasonic energy can be uniformly transferred to the entire substrate to further improve the fine particle removal efficiency.
(4) Particularly, when the hydrogencarbonate water is preheated at a preset temperature, e.g. 50°C to 85°C, and used, the acidity, reducing power and electric conductivity can be further improved to suppress formation of an oxide film and also further improve the cleaning effect through removal of fine particles.

### Brief Description of Drawing

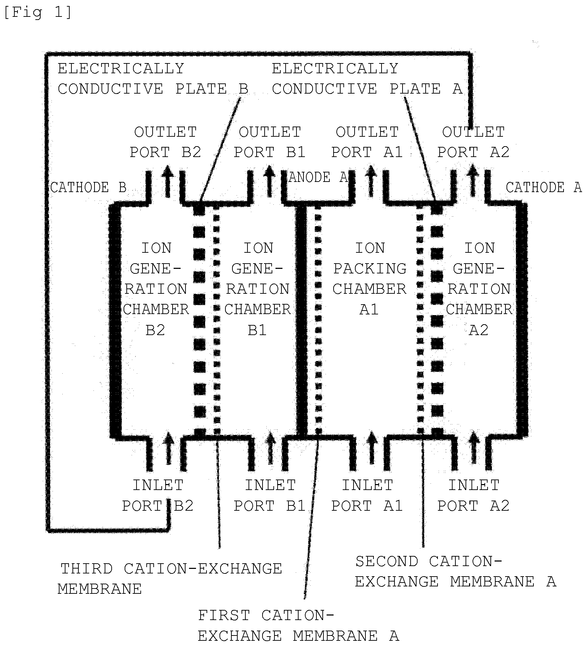

Figure 1 is a schematic view of an example of an electrolysis apparatus usable for production of hydrogen water in the present invention.

### Mode of Carrying Out the Invention

Hydrogencarbonate water of the present invention is obtained by dissolving carbon dioxide in hydrogen water having a dissolved hydrogen concentration of 0.1 ppm to 2.0 ppm. In addition, in the hydrogencarbonate water of the present invention, it is preferable that the hydrogen water in which carbon dioxide is dissolved has a pH of 5.5 to 6.8, an oxidation-reduction potential of -200 mV to - 700 mV and a dissolved hydrogen concentration of 0.1 ppm to 2.0 ppm. The oxidation-reduction potential of the hydrogen water is more preferably -200 mV to -650 mV. In addition, in the hydrogencarbonate water of the present invention, hydrogen water having a dissolved hydrogen concentration of 0.1 ppm to 2.0 ppm, or hydrogen water having a pH of 5.5 to 6.8, an oxidation-reduction potential of -200 mV to -700 mV and a dissolved hydrogen concentration of 0.1 ppm to 2.0 ppm as well as the hydrogen water having an oxidation-reduction potential of -200 mV to -650 mV is preferably hydrogen water obtained by dissolving hydrogen gas in pure water or ultrapure water, or hydrogen water obtained by electrolyzing pure water or ultrapure water. In addition, it is preferable that the hydrogencarbonate water of the present invention has a pH of 4.0 to 6.8, an oxidation-reduction potential of -50 mV to -650 mV and an electric conductivity of 0.072 µS/cm to 80 µS/cm. The oxidation-reduction potential of the hydrogencarbonate water of the present invention is more preferably -300 mV to -650 mV, still more preferably -400 mV to -650 mV. The electric conductivity of the hydrogencarbonate water of the present invention is more preferably 10 µS/cm to 80 pS/cm, still more preferably 10 µS/cm to 60 µS/cm. The hydrogencarbonate water having these characteristics can be obtained by dissolving carbon dioxide in the above hydrogen water.

The object to be cleaned by a cleaning method of the present invention is not particularly limited, but the cleaning method can be suitably used for cleaning a substrate such as a substrate to be used in preparation of a semiconductor wafer, an organic EL (OLED), a photomask, an LCD, a hard disk or the like. In the cleaning method of the present invention, a substrate to be cleaned is immersed in the hydrogencarbonate water of the present invention, or the hydrogencarbonate water of the present invention is sprayed to the substrate, whereby the substrate can be cleaned. In addition, in the cleaning method of the present invention, it is preferable that the substrate is cleaned by spraying the hydrogencarbonate water to the substrate for 5 to 10 minutes while rotating the substrate at 80 to 300 rpm and applying a megasonic at 1 to 3 MHz to the hydrogencarbonate water of the present invention. In addition, in the cleaning method of the present invention, it is preferable that the hydrogencarbonate water of the present invention is preheated at 40°C to 85°C, and used, and it is more preferable that the hydrogencarbonate water of the present invention is preheated at 50°C to 85°C, and used. In the cleaning method of the present invention, fine particles as a contaminating substance can be removed at a removal ratio of 80% or more, or 90% or more.

Hereinafter, preferred examples of the present invention will be described in more detail with reference to attached drawings. It is to be noted in advance that the terms and words used in the description of the present application and claims should not be interpreted as common or having indeterminate meanings in a limited way, and should be interpreted with meanings and concepts consistent with the technical idea of the present invention on the basis of the principle that the inventor can appropriately define concepts of terms for explaining the invention of the inventor himself or herself in an optimum manner.

Therefore, it should be understood that since examples described in the description of the present application and configurations shown in the drawings are merely the most desirable examples of the present invention, and do not represent all aspects of the technical idea of the present invention, various equivalents and modifications substitutable for these examples may exist at the time of filing the present application.

In the method of cleaning a substrate according to the present invention, the substrate is cleaned using hydrogencarbonate water. Thus, the hydrogencarbonate water will be first described here, and the cleaning method using the hydrogencarbonate water will be described later. Hereinafter, the pH and oxidation-reduction potential (ORP), the electric conductivity, the carbon dioxide concentration and the dissolved hydrogen concentration were measured using the following devices, respectively.
(1) pH and oxidation-reduction potential (ORP): HM-31P from DKK-TOA Corporation
(2) Electric conductivity: CM-21PW from TOA Corporation
(3) Carbon dioxide concentration: 7515 from TSI
(4) Dissolved hydrogen concentration: DH-35A from DKK-TOA Corporation

### (Production of hydrogencarbonate water)

The hydrogencarbonate water of the present invention can be obtained by dissolving carbon dioxide (CO₂) in hydrogen water. At this time, as the hydrogen water, hydrogen water obtained by dissolving hydrogen gas in purified water with an electric conductivity of 50 µS or less, such as pure water or ultrapure water, or electrolyzing the purified water can be suitably used. The hydrogen water is preferably hydrogen water having a dissolved hydrogen concentration of 0.1 ppm to 2.0 ppm. Further, the hydrogen water in the present invention is preferably hydrogen water obtained by electrolyzing purified water with an electric conductivity of 50 µS/cm or less, such as pure water or ultrapure water. Particularly, in a preferred embodiment, it is preferable that the hydrogen water obtained in this manner has a pH of 5.5 to 6.8, an oxidation-reduction potential (ORP) of - 200 mV to -700 mV and a dissolved hydrogen concentration of 0.1 ppm to 2.0 ppm. As the hydrogencarbonate water obtained by dissolving carbon dioxide (CO₂) in the hydrogen water, one having a pH of 4.0 to 6.8, an oxidation-reduction potential of -50 mV to -650 mV and an electric conductivity of 0.072 µS/cm to 80 µS/cm can be preferably used. The concentration of carbon dioxide (CO₂) in the hydrogencarbonate water is preferably 0.1 ppm to 2.0 ppm, more preferably 0.5 ppm to 2.0 ppm.

When hydrogen water is to be obtained by electrolyzing purified water with an electric conductivity of 50 µS/cm or less, such as pure water or ultrapure water, the electrolysis method is not particularly limited as long as hydrogen water having a dissolved hydrogen concentration of 0.1 ppm to 2.0 ppm can be obtained, and for example, a method can be suitably shown which uses an electrolysis apparatus (Figure 1) in which two cathode plates are placed with one anode plate held therebetween, a cation-exchange membrane is provided on one cathode plate side of the anode plate with the membrane in contact with the side, an electrically conductive plate with the cation-exchange membrane provided on the anode plate side with the membrane in contact with the side and with a large number of minute pores drilled in the electrically conductive plate is provided between a pair of electrode plates (between the anode plate and one cathode plate and between the anode plate and the other cathode plate), water is caused to flow separately between the anode plate and the electrically conductive plate and between the cathode plate and the electrically conductive plate, and treated water flowing between the cathode plate and the electrically conductive plate is utilized.

Thus, the hydrogencarbonate water of the present invention, which is obtained by dissolving carbon dioxide (CO₂) in hydrogen water obtained by dissolving hydrogen gas in purified water or electrolyzing purified water, has a pH of 4.0 to 6.8, and hence acidity higher than that of hydrogen water having a pH of 5.5 to 6.8, and particularly, while existing carbonated water has oxidizing power in terms of an oxidation-reduction potential (ORP), the hydrogencarbonate water of the present invention has reducing power (-50 mV to -650 mV) in terms of the ORP, so that generation of an oxide film in patterns formed on a substrate at the time of cleaning the substrate is prevented.

### (Cleaning of substrate)

One embodiment of a process of cleaning a substrate using the hydrogencarbonate water of the present invention is as follows. First, the substrate is cleaned by spin cleaning in which the substrate is cleaned while being rotated at a predetermined rotation speed. At this time, the substrate is rotated at a speed of preferably 80 to 300 rpm. On the other hand, to a surface of the substrate which is rotated in this manner, the hydrogencarbonate water of the present invention is sprayed using a nozzle or the like. At this time, by applying a megasonic at 1 to 3 MHz to give high-frequency energy to the hydrogencarbonate water, energy of high-frequency vibration or the like can be utilized to uniformly clean the entire substrate by this energy. The hydrogencarbonate water is continuously sprayed for 5 to 10 minutes. In addition, as another embodiment, mention is made of a method in which the substrate is immersed in a container filled with the hydrogencarbonate water of the present invention, or a method in which in the foregoing method, a megasonic at 1 to 3 MHz is applied to the hydrogencarbonate water in the container.

In this way, improvement of the yield and improvement of quality can be achieved by removing organic substances and fine particle impurities on a surface of the substrate, and particularly, since a chemical agent is not used, and therefore there is no rinsing step, the cleaning step can be simplified. Further, formation of an oxide film on patterns formed on the substrate is suppressed through reducing power of the hydrogencarbonate water, so that improvement of quality can be expected together with a cleaning effect. In a preferred embodiment of the present invention, it is preferable that the hydrogencarbonate water is preheated at a predetermined temperature, preferably 40°C to 85°C, more preferably 50°C to 85°C, and used for cleaning in the cleaning method of the present invention. This is because in this range, the hydrogencarbonate water exhibits the highest oxidation-reduction potential, and resultantly has the strongest reducing power.

### Example 1

### (Example of production of hydrogencarbonate water)

First, ultrapure water was electrolyzed to obtain hydrogen water. The hydrogen water at this time had a pH of 6.5 and an oxidation-reduction potential of -683 mV. Subsequently, the hydrogen water was added in an airtight container, and 2 ppm of carbon dioxide (CO₂) was dissolved in the hydrogen water to obtain hydrogencarbonate water. The hydrogencarbonate water at this time had a pH of 4.6, an oxidation-reduction potential (ORP) of -470 mV and an electric conductivity of 43.2 µS/cm.

### (Property change depending on carbon dioxide concentration)

The results of comparing the changes of the pH, the oxidation-reduction potential (ORP) and the electric conductivity based on the concentration of carbon dioxide (CO₂) in the hydrogen water and hydrogencarbonate water obtained in this manner are as shown in Table 1. From Table 1, it is apparent that as the concentration of carbon dioxide was increased, higher acidity was exhibited, it was possible to have reducing power although the oxidation-reduction potential was slightly reduced, and the electric conductivity was rapidly increased.

**[Table 1]**

| CO₂ concentration | 0 ppm | 0.5 ppm | 1 ppm |
|---|---|---|---|
| pH | 6.5 | 5.2 | 4.5 |
| ORP (mV) | -680 | -510 | -437 |
| Electric conductivity (µS/cm) | 0.25 | 15 | 45 |

### Example 2

### (Example of cleaning of substrate)

A silicon wafer oxidized with ozone water was contaminated with Al₂O₃ and a CMP slurry at a density of 5,000 contaminants per wafer, and hydrogencarbonate water at normal temperature (pH: 4.9, ORP: -500 mV, electric conductivity: 18 µS/cm) obtained by the same method as in Example 1 was then sprayed to a surface of the substrate by a spray nozzle system while the substrate was rotated at 80 rpm. At this time, a megasonic at 2 MHz was applied, and the spraying was continued for 8 minutes. As a result, contaminating substances (> 0.07 µm) were removed at a removal ratio of 80% or more.

### Industrial Applicability

The hydrogencarbonate water of the present invention can be suitably used as a cleaning liquid for a substrate to be used particularly in preparation of a semiconductor wafer, an organic EL (OLED), a photomask, an LCD, a hard disk or the like. The cleaning method of the present invention can be suitably used for cleaning a substrate to be used particularly in preparation of a semiconductor wafer, an organic EL (OLED), a photomask, an LCD, a hard disk or the like.

## Claims

1. Hydrogencarbonate water obtained by dissolving carbon dioxide in hydrogen water having a dissolved hydrogen concentration of 0.1 ppm to 2.0 ppm.

2. The hydrogencarbonate water according to claim 1, wherein the hydrogen water has a pH of 5.5 to 6.8, an oxidation-reduction potential of -200 mV to -700 mV and a dissolved hydrogen concentration of 0.1 ppm to 2.0 ppm.

3. The hydrogencarbonate water according to claim 1 or 2, wherein the hydrogen water is hydrogen water obtained by dissolving hydrogen gas in pure water or ultrapure water, or hydrogen water obtained by electrolyzing pure water or ultrapure water.

4. Hydrogencarbonate water having a pH of 4.0 to 6.8, an oxidation-reduction potential of -50 mV to -650 mV and an electric conductivity of 0.072 µS/cm to 80 µS/cm.

5. The hydrogencarbonate water according to any one of claims 1 to 3, wherein the hydrogencarbonate water has a pH of 4.0 to 6.8, an oxidation-reduction potential of -50 mV to -650 mV and an electric conductivity of 0.072 µS/cm to 80 µS/cm.

6. A cleaning method comprising cleaning a substrate by immersing the substrate in the hydrogencarbonate water according to any one of claims 1 to 5, or spraying to the substrate the hydrogencarbonate water according to any one of claims 1 to 5.

7. The cleaning method according to claim 6, wherein the substrate is cleaned by spraying the hydrogencarbonate water to the substrate for 5 to 10 minutes while rotating the substrate at 80 to 300 rpm and applying a megasonic at 1 to 3 MHz to the hydrogencarbonate water.

8. The cleaning method according to claim 6 or 7, wherein the hydrogencarbonate water is preheated at 40°C to 85°C.
